# EUROPÄISCHE PATENTSCHRIFT

(11) **EP 2 465 336 B1**
(45) Veröffentlichungstag und Bekanntmachung des Hinweises auf die Patenterteilung: **08.01.2014**
(21) Anmeldenummer: 10728723.7
(22) Anmeldetag: 08.07.2010
(51) Int. Cl.: H05K 5/02

(54) **AUFNAHMEVORRICHTUNG FÜR EINE MODULARE TELEMATIKEINHEIT**
RECEIVING DEVICE FOR A MODULAR TELEMATICS UNIT
SOCLE POUR UNE UNITE TELEMATIQUE MODULAIRE

(30) Priorität: 14.08.2009 DE 102009037295
(43) Veröffentlichungstag der Anmeldung: 20.06.2012
(73) Patentinhaber: Deutsche Post AG, 53113 Bonn (DE)
(72) Erfinder: JOSEFIAK, Frank, 53177 Bonn (DE); AFTABRUYAN, Hassan, 51069 Köln (DE); Heimerl, Stefan, 84034 Landshut (DE); BAUGATZ, Julian, 10247 Berlin (DE); WIECHMANN, Andreas, 21365 Adendorf (DE)
(74) Vertreter: Jostarndt, Hans-Dieter
(86) Internationale Anmeldenummer: PCT/EP2010/059797
(87) Internationale Veröffentlichungsnummer: WO 2011/018282

(56) Entgegenhaltungen:
- GB-A- 2 359 208
- US-A1- 2007 272 044
- US-A1- 2008 061 963

## Beschreibung

Die Erfindung betrifft eine Aufnahmevorrichtung für eine modulare Telematikeinheit.

Aus dem Stand der Technik ist es bekannt, Transportbehälter wie Frachtcontainer oder Wechselbrücken mit Telematikeinheiten zu versehen. Mit diesen Telematikeinheiten wird üblicherweise wenigstens die Position eines Transportcontainers verfolgt und fortlaufend an eine zentrale Datenverarbeitungsanlage übermittelt. Die Datenübermittlung kann dabei beispielsweise über ein GPS-Modul erfolgen, das in die Telematikeinheit integriert ist. Ferner kann der Zustand von Inhalten des Transportbehälters mittels Sensoren gemessen und diese Zustandsdaten ebenfalls fortlaufend an die zentrale Datenverarbeitungsanlage übermittelt werden. Ist keine fortlaufende Datenübermittlung erforderlich, kann ein Speicher zum Speichern relevanter Daten vorgesehen sein, aus dem diese dann zu einem späteren Zeitpunkt ausgelesen werden können. Diese Funktionen sind jedoch nur als Beispiel anzusehen und können durch jegliche andere Funktionen und Funktionsweisen ersetzt oder ergänzt werden, die für das bestimmte Anwendungsgebiet einer Telematikeinheit erforderlich sind.

Die Telematikeinheiten können an den Transportbehältnissen mittels Aufnahmevorrichtungen lösbar befestigt werden. Solche Aufnahmevorrichtungen sind beispielsweise aus der US 2007/272044 A1 bekannt. Dort wird eine Fernsteuerung und eine Befestigung, die lösbar auf die Fernsteuerung montiert ist, offenbart. Die Befestigung ist hinter der Fernsteuerung völlig verborgen, wodurch die ästhetische Qualität der Fernsteuerung erhöht wird. Die Fernsteuerung ist in einen Montagesitz der Befestigung leicht einschiebbar. Die Fernsteuerung ist durch axiale Bewegung in einen Befestigungshaken der Befestigung einrastbar, womit die Fernsteuerung leicht und schnell befestigt werden kann.

In allen Ausführungsformen benötigt die Telematikeinheit jedoch Energie, um die verschiedenen Funktionen erfüllen zu können. Auch dazu sind aus dem Stand der Technik verschiedene Lösungen bekannt, um eine Telematikeinheit beispielsweise über eine Batterie, einen Akkumulator, ein Solarpanel oder durch Windkraft kontinuierlich oder temporär mit Energie zu versorgen. Beispielsweise beschreibt die US 2008/0611963 A1 eine Vorrichtung, die an einer Außenfläche eines Transportbehälters angebracht ist, und die für Verfolgung des Transportbehälters ein Solarpanel, eine Batterie, ein GPS-Modul, ein Mobilfunk-Daten-Transceiver-Modul und einen Mikrocontroller zum Steuern des GPS-Moduls und des Mobilfunk-Daten-Transceiver-Moduls umfasst. Die Position des Transportbehälters kann periodisch erfasst und an eine Verfolgungsdatenbank eines zentralen Verfolgungscomputers übertragen werden. Das Solarpanel, die Batterie, das GPS-Modul, das Mobilfunk-Daten-Transceiver-Modul und der Mikrocontroller werden in eine einteilige, wasserdichte Mastersteuereinheit integriert. Die Mastersteuereinheit kann weiterhin ein lokales drahtloses Funk-Daten-Transceiver-Modul umfassen, mit dem die Kommunikation mit Funksensoren innerhalb des Transportbehälters durch die Wände des Transportbehälters ermöglicht wird.

Derartige Telematikeinheiten können somit verschiedene elektronische Bauteile aufweisen, die je nach Anwendungsgebiet geeignet kombiniert und üblicherweise in einem Gehäuse eingeschlossen werden. Möglich ist es auch, die einzelnen Bauteile der Telematikeinheit einzeln an einem Transportbehälter anzubringen oder in diesen zu integrieren. Wird die gesamte Telematikeinheit oder Teile davon außen an einem Transportbehälter angebracht, sollte sie zudem wetterfest ausgeführt sein. Wird beispielsweise für die Energieversorgung ein Solarpanel eingesetzt, muss dies so außen an dem Transportbehälter angebracht werden, dass es für bestimmte Zeiträume dem Sonnenlicht ausgesetzt ist, jedoch beim Gebrauch des Transportbehälters nicht beschädigt wird. Das aus der US 2008/0611963 A1 bekannte Solarmodul wird allerdings je nach Einsatzort und dortiger Witterung nicht in der Lage sein, über einen längeren Zeitraum eine effiziente Energieversorgung zu gewährleisten, da die Oberfläche mit der Zeit durch die Witterung verschmutzen und somit den Wirkungsgrad des Solarpanels herabsetzen wird.

Üblicherweise werden für jeden Anwendungsfall die elektronischen Bauteile einer Telematikeinheit inklusive eines Solarpanels kombiniert, miteinander verbunden und geeignet an dem Transportbehälter dieses bestimmten Anwendungsfalls angebracht. Eine universell einsetzbare Telematikeinheit für verschiedene Anwendungsfälle, die auch über einen längeren Zeitraum eine effiziente Energieversorgung aufweist, wurde jedoch bisher nicht bereitgestellt. Aufgabe der Erfindung ist es daher, eine Telematikeinheit bereitzustellen, welche diese Aufgabe erfüllt.

Erfindungsgemäß wird diese Aufgabe durch eine Aufnahmevorrichtung für eine modulare Telematikeinheit mit den Merkmalen des unabhängigen Anspruchs 1 gelöst. Vorteilhafte Weiterbildungen der Aufnahmevorrichtung ergeben sich aus den Unteransprüchen 2-9. Die Aufgabe wird ferner durch einen Transportbehälter mit einer solchen Aufnahmevorrichtung nach Anspruch 10 und 11 gelöst.

Die erfindungsgemäße Aufnahmevorrichtung für eine modulare Telematikeinheit weist einen Grundkörper auf, der wenigstens zwei gegenüber liegende Schienen umfasst, wobei der Grundkörper eine Bodenplatte aufweist, an deren Seiten die Schienen angebracht sind, wobei zwischen die Schienen lösbar wenigstens ein Gehäuse und ein Solarpanel eingeschoben sind, wobei das Gehäuse wesentliche Komponenten der modularen Telematikeinheit aufnimmt, wobei eine Schrägstellung des Solarpanels durch die Schienen erreicht wird, indem parallel zu der Bodenplatte verlaufen und der jeweilige Abstand der Schienen zu den Bodenplatte unterschiedlich ist, wodurch die äußere Oberfläche des Solarpanels schräg in einem Winkel α zu der äußeren, gegenüber liegenden Oberfläche der Bodenplatte verläuft.

Das Gehäuse ist vorzugsweise mehrteilig ausgebildet, wobei es durch einen flachen Längsschnitt in wenigstens zwei Gehäusehälften aufgeteilt ist. In einem Ausführungsbeispiel der Erfindung besteht das Gehäuse aus glasfaserverstärktem Kunststoff, was sich als vorteilhaftes Material für Anwendungen unter verschiedenen Klimabedingungen eignet. Ferner können aus dem Material auf einfach Weise verschiedene Aufnahmen in dem Gehäuse ausgeformt werden, wobei in die jeweilige Aufnahme beispielsweise ein Akkumulator, ein GPS-Modul, ein Funkmodul, ein Sensor oder eine Platine eingebracht werden können.

Vorzugsweise steht die äußere Oberfläche des Solarpanels schräg in einem Winkel α gegenüber wenigstens einer äußeren, gegenüber liegenden Oberfläche des Grundkörpers. Bei dieser Bezugsoberfläche des Grundkörpers handelt es sich beispielsweise um die äußere Oberfläche der Bodenplatte der Aufnahmevorrichtung. Der Winkel α liegt zwischen 1° bis 5°, was dazu führt, dass Verschmutzungen sich weniger auf dem schrägen Solarpanel ablagern oder zumindest durch Regenwasser und Wind wieder abgespült werden.

Die Schrägstellung des Solarpanels kann auf verschiedene Arten erreicht werden. Beispielsweise ist es möglich, dass die Schienen gegenüber der wenigstens einen äußeren, gegenüber liegenden Oberfläche des Grundkörpers schräg in einem Winkel α verlaufen.

In einem anderen Ausführungsbeispiel der Erfindung verlaufen die Schienen parallel zu der wenigstens einen äußeren, gegenüber liegenden Oberfläche des Grundkörpers, der jeweilige Abstand der Schienen zu der äußeren, gegenüber liegenden Oberfläche des Grundkörpers ist jedoch unterschiedlich, wodurch die äußere Oberfläche des Solarpanels wiederum schräg in einem Winkel α zu der wenigstens einen äußeren, gegenüber liegenden Oberfläche des Grundkörpers verläuft.

Vorzugsweise weist der Grundkörper eine Bodenplatte auf, an deren Seiten die Schienen angebracht sind, wobei zwischen der Bodenplatte des in die Schienen eingeschobenen Gehäuses und der Bodenplatte des Grundkörpers ein Luftraum vorliegt. Der Luftraum ermöglicht eine Belüftung des Gehäuses und der darin befindlichen elektronischen Komponenten. Die Höhe h des Luftraums liegt zwischen 0,5 mm und 8 mm.

In einem Ausführungsbeispiel der Erfindung ist das Gehäuse mit wenigstens zwei Schraubverbindungen an dem Grundkörper befestigt, wobei eine erste Schaubverbindung ein Festlager ist, während eine zweite Schraubverbindung ein Loslager mit einem Langloch umfasst. Hierdurch können unterschiedliche Ausdehnungen verschiedener Materialien des Gehäuses und des Grundkörpers der Aufnahmevorrichtung trotz einer festen Verbindung ausgeglichen werden.

Vorzugsweise umfasst der Grundkörper wenigstens einen Magneten, mit dem die Aufnahmevorrichtung an metallischen Gegenständen wie beispielsweise einem Frachtcontainer befestigt werden kann.

Von der Erfindung umfasst ist ferner ein Transportbehälter, an welchem eine erfindungsgemäße Aufnahmevorrichtung angebracht ist. Dieser Transportbehälter kann beispielsweise ein Frachtcontainer oder eine Wechselbrücke sein, wobei der Transportbehälter an seiner Außenseite rillenförmige Vertiefungen (Dachsicken) aufweist und die Aufnahmevorrichtung in eine rillenförmige Vertiefung eingebracht ist. Eine Montage ist jedoch auch ohne das Vorhandensein von Sicken möglich.

Ein wesentlicher Vorteil der erfindungsgemäßen Aufnahmevorrichtung für eine modulare Telematikeinheit besteht in der autarken Energieversorgung durch ein integriertes Solarpanel. Sowohl die Aufnahmevorrichtung als auch das darin eingeschobene Gehäuse sind so ausgestaltet, dass modulartig jegliche Einheiten wie weitere Solarpanels, Akkus, sensorische Einheiten, Funk-Module, etc. ergänzt und so kombiniert werden können. Die Aufnahmevorrichtung ist einfach zu montieren und zu demontieren, wobei sie sich aufgrund ihrer Geometrie insbesondere zur Montage in Dachsicken von Containern eignet. Dabei ist die gesamte Vorrichtung sehr robust, was insbesondere bei der Verwendung für Frachtcontainer und Wechselbrücken von großer Bedeutung ist.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: eine schematische Aufsicht eines Ausführungsbeispiels der erfindungsgemäßen Aufnahmevorrichtung für eine modulare Telematikeinheit;
- Fig. 2: eine Rückansicht eines Ausführungsbeispiels einer Aufnahmevorrichtung für eine modulare Telematikeinheit;
- Fig. 3: eine Gehäusehälfte gemäß Fig. 2 mit eingebauten Telematikbauteilen;
- Fig. 4: eine Gehäusehälfte gemäß Fig. 2 mit eingebauten Telematikbauteilen;
- Fig. 5: zwei Gehäusehälften nach dem Zusammenbau zu einem Gehäuse;
- Fig. 6: eine Draufsicht auf einen Transportbehälter mit einer Aufnahmevorrichtung für eine modulare Telematikeinheit; und
- Fig. 7: einen Ausschnitt aus der Oberseite eines Transportbehälters mit einer daran angebrachten Aufnahmevorrichtung für eine modulare Telematikeinheit.

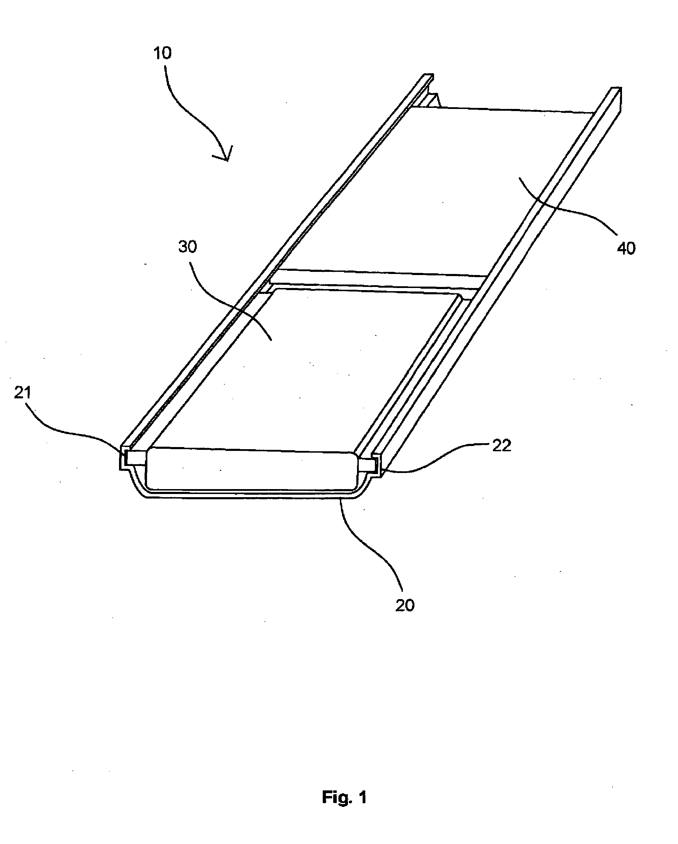

Fig. 1 zeigt eine schematische Darstellung eines Ausführungsbeispiels der erfindungsgemäßen Aufnahmevorrichtung 10, wobei die Aufnahmevorrichtung 10 eine rechteckige Bodenplatte 23 und zwei seitliche Schienen 21 und 22 umfasst. Zwischen diese Schienen 21 und 22 können unterschiedliche Bauteile einer modularen Telematikeinheit eingeschoben und so je nach Anwendungsfall miteinander kombiniert werden. Die einzelnen Bauteile können unabhängig voneinander arbeiten oder auch miteinander verbunden sein.

Erfindungsgemäß sind wenigstens ein flaches Solarpanel 40 und ein Gehäuse 30 zwischen den Schienen 21 und 22 eingeschoben. Das Einschieben dieser Bauteile kann sowohl von einem als auch von beiden kurzen Enden der Aufnahmevorrichtung erfolgen. Erfolgt das Einschieben lediglich von einem kurzen Ende her, kann an dem gegenüber liegenden Ende ein Anschlag vorgesehen sein, gegen den alle Komponenten geschoben werden können. Diese Ausführungsform mit einem Anschlag hat den Vorteil, dass nur das letzte eingeschobene Bauteil an dem Grundkörper 20 befestigt werden muss. Ohne Anschlag sollten alle Bauteile an dem Grundkörper befestigt werden, was beispielsweise durch Schraub- und/oder Stiftverbindungen erfolgen kann. Bei geeigneter Wahl der Abmessungen ist alternativ oder ergänzend auch ein Einpressen der Bauteile zwischen die Schienen möglich.

Die Aufnahmevorrichtung 10 ist vorzugsweise flach und länglich ausgebildet, so dass zwischen den Schienen 21 und 22 mehrere, ebenfalls flache, Bauteile nacheinander eingeschoben werden können. Die Länge der Aufnahmevorrichtung beträgt in einem Ausführungsbeispiel der Erfindung 20 cm, während die Breite vorzugsweise bei 11 cm liegt. Eine Breite von 11 cm ermöglicht die Einbringung der Aufnahmevorrichtung 10 zusammen mit Telematikbauteilen in rillenförmige Vertiefungen (Dachsicken) an den Außenseiten von Frachtcontainern oder Wechselbrücken, die sich durch die Versteifung von metallischen Seitenwänden dieser Transportbehälter ergeben. Diese rillenförmigen Vertiefungen haben standardmäßig eine Breite von ca. 12 cm und eine Tiefe von ca. 2 cm.

Ferner ergibt sich die Höhe der Aufnahmevorrichtung 10 beispielsweise durch die Tiefe der rillenförmigen Vertiefungen in den Seitenwänden der Transportbehälter, da die erfindungsgemäße Aufnahmevorrichtung möglichst flach ausgeführt sein soll, damit sie annähernd bündig in eine rillenförmige Vertiefung eingebracht werden kann. So ragt die Aufnahmevorrichtung nicht oder nur geringfügig über die Ränder der Vertiefungen hinaus, wodurch sie insbesondere möglichst wenig mechanischen Belastungen ausgesetzt ist. Dies senkt das Risiko einer Beschädigung der erfindungsgemäßen Aufnahmevorrichtung. Eine Höhe von maximal 3 cm hat sich somit als vorteilhaft erwiesen.

Die Länge der Aufnahmevorrichtung kann dagegen beliebig gewählt werden. Insbesondere können auch mehrere der erfindungsgemäßen Aufnahmevorrichtungen hintereinander in einer rillenförmigen Vertiefung angebracht und auch miteinander gekoppelt werden.

Die Schienen 21 und 22 können beispielsweise durch zwei Nuten in den Seitenwänden des Grundköpers 20 gebildet werden. Es besteht dabei die Möglichkeit, dass diese Nuten nicht parallel, sondern in einem Winkel zueinander verlaufen. An einem kurzen Ende der Aufnahmevorrichtung wäre der Abstand zwischen den Nuten somit größer als an dem anderen kurzen Ende. In diesem Fall könnten Telematikbauteile von dem Ende mit dem größeren Nutabstand in die Schienen eingeschoben werden und würden bei aufeinander zulaufenden Nuten ab einem bestimmten Punkt zwischen die Nuten gepresst, was zu einer Fixierung der Bauteile innerhalb der Schienen führt. Die Geometrie der Telematikbauteile könnte ebenfalls so gewählt werden, dass dieser Effekt unterstützt wird.

Zwischen die Schienen 21 und 22 ist erfindungsgemäß wenigstens ein Solarpanel 40 eingeschoben. Das Solarpanel ist flach ausgebildet und ragt vorzugsweise nicht oder nur geringfügig über die Oberkanten der Schienen hinaus. Das Solarpanel 40 kann dazu mit seiner jeweiligen Seitenfläche in den Nuten der Schienen geführt sein, oder das Solarpanel weist seitliche Federn auf, die in den Nuten der Schienen geführt sind.

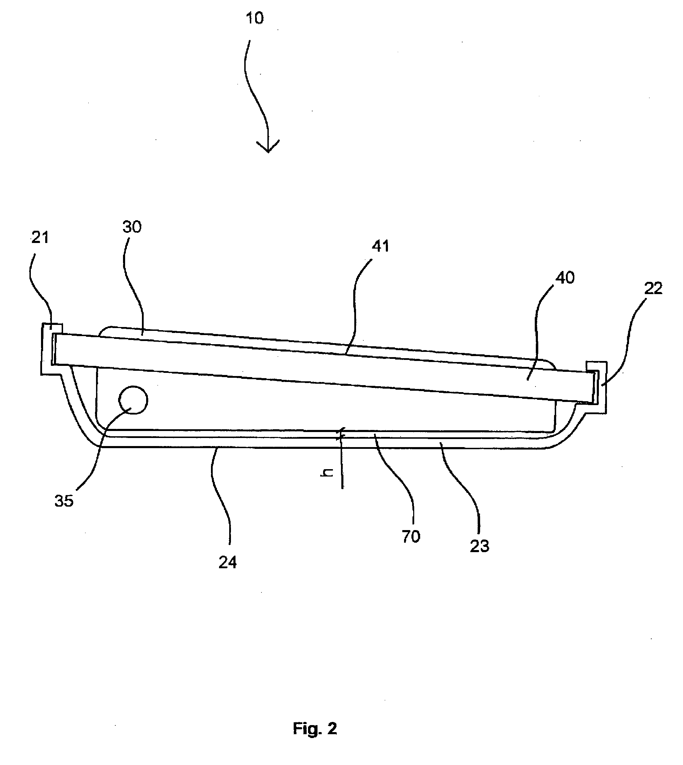

Die Fig. 2 zeigt schematisch die Rückansicht eines Ausführungsbeispiels der Erfindung, so dass das Solarpanel 40 nun vor dem hinten liegenden Gehäuse 30 dargestellt ist. Das Solarpanel 40 ist mit seinen jeweiligen Seitenflächen in Nuten der Schienen 21 und 22 geführt. Hierbei ist vorgesehen, dass die äußere Oberfläche 41 des Solarpanels 40 schräg steht und somit in einem Winkel α zu der äußeren Oberfläche 24 des Grundkörpers 20 der Aufnahmevorrichtung 10 verläuft. Dies wird beispielsweise dadurch erreicht, dass die beiden Schienen 21 und 22 in Bezug zur Bodenplatte 23 auf unterschiedlichen Höhen angeordnet sind. In Bezug zur Bodenplatte 23 des Grundkörpers 20 steht das Solarpanel 40 somit schräg, wobei sich ein Winkel α zwischen 1° und 5° als vorteilhaft erwiesen haben.

Wird der Grundkörper 20 so auf einem Transportbehälter montiert, dass die Bodenplatte 23 auf dem Transportbehälter aufliegt, steht das Solarpanel 40 somit auch schräg zur betreffenden Außenfläche des Transportbehälters. Vorzugsweise wird die Aufnahmevorrichtung so auf einem Transportbehälter wie einem Frachtcontainer oder einer Wechselbrücke montiert, dass die Schrägstellung des Solarpanels 40 gegen die Transport- bzw. Fahrtrichtung des Behälters gerichtet ist. Dies hat den vorteilhaften Effekt, dass Verschmutzungen auf dem Solarpanel bei Bewegung des zugehörigen Transportbehälters automatisch durch Regenwasser und/oder Wind abgelöst werden. Auch beim Stillstand eines Transportbehälters kann die Oberfläche eines Solarpanels durch Regenwasser abgespült werden und das Regenwasser läuft zu einer Seite des Solarpanels ab. Im günstigsten Fall bilden sich auf dem Solarpanel gar keine Verschmutzungen, sondern auch diese fließen oder fallen zu einer Seite des Solarpanels hin ab.

In dem in Fig. 2 dargestellten Ausführungsbeispiel der Erfindung liegt somit eine Schrägstellung des Solarpanels vor, die durch unterschiedlich hohe Schienen erreicht wird.

In dem in Fig. 2 dargestellten Ausführungsbeispiel der Erfindung liegt somit eine Schrägstellung des Solarpanels 40 quer zur Längsachse der Aufnahmevorrichtung vor. Dies bedeutet, dass die Aufnahmevorrichtung vorzugsweise quer zur Transport- bzw. Fahrtrichtung eines Behälters montiert wird, um den größtmöglichen Reinigungseffekt zu erzielen. Dies ist oftmals der Fall, da rillenförmige Vertiefungen in der Oberseite eines Frachtcontainers oder einer Wechselbrücke üblicherweise ebenfalls quer zur Transport- bzw. Fahrtrichtung eines Behälters verlaufen, um die Steifigkeit der Dachkonstruktion in Fahrtrichtung zu erhöhen. Soll eine Aufnahmevorrichtung jedoch entlang der Transport- bzw. Fahrtrichtung eines Behälters montiert werden, kann die Schrägstellung des Solarpanels 40 auch durch Schienen erreicht werden, die zwar jeweils auf gleicher Höhe, jedoch nicht parallel zu der Bodenplatte des Grundkörpers verlaufen. In diesem Fall verlaufen die Schienen 21 und 22 in einem Winkel von α zur äußeren Oberfläche 24 der Bodenplatte.

Der Fig. 2 ist ferner zu entnehmen, dass das Gehäuse 30 vorzugsweise mit einem Abstand h zur Bodenplatte 23 der Aufnahmevorrichtung montiert ist. So ergibt sich ein Luftraum 70, der zur Belüftung des Gehäuses 30 bzw. der darin angeordneten elektronischen Bauteile dient. Dieser Abstand h beträgt in der Mitte der Aufnahmevorrichtung vorzugsweise wenigstens 0,5 mm.

Das Gehäuse 30 ist vorzugsweise mehrteilig ausgeführt und besteht wenigstens aus zwei Gehäusehälften, die sich durch einen flachen Längsschnitt durch das Gehäuse ergeben. Zusammengefügt ergeben die Gehäusehälften ein flaches Gehäuse, dass über seine Seitenwände in die Schienen 21 und 22 der Aufnahmevorrichtung einschiebbar ist. Dazu können an den Seiten des Gehäuses 30 Federn angebracht sein, die in den Nuten der Schienen geführt werden. Alternativ kann das Gehäuse über seine Seitenflächen in den Schienen geführt werden.

Ein flacher Längsschnitt bedeutet hierbei, dass das vorzugsweise rechteckige Gehäuse 30 entlang seiner Längsachse und durch die niedrigen Seitenwände geschnitten wird, wobei sich eine untere und eine obere Gehäusehälfte ergeben, deren Schnittöffnungen jeweils den Innenraum der jeweiligen Gehäusehälfte freigeben. Beide Gehäusehälften sind vorzugsweise aus glasfaserverstärktem Kunststoff ausgebildet, wodurch sich auf einfache Weise beliebige äußere Geometrien und innere Formen bilden lassen. In einem Ausführungsbeispiel der Erfindung ist das Material des Gehäuses möglichst hell und in das Material des Gehäuses können reflektierende Partikel eingearbeitet sein, um eine zu hohe Aufheizung des Gehäuses bei Sonneneinstrahlung zu verhindern. Das Gehäuse nimmt wesentliche Komponenten einer modularen Telematikeinheit auf, so dass innerhalb des Gehäuses vorzugsweise Aufnahmen verschiedener Form und Größe ausgebildet sind.

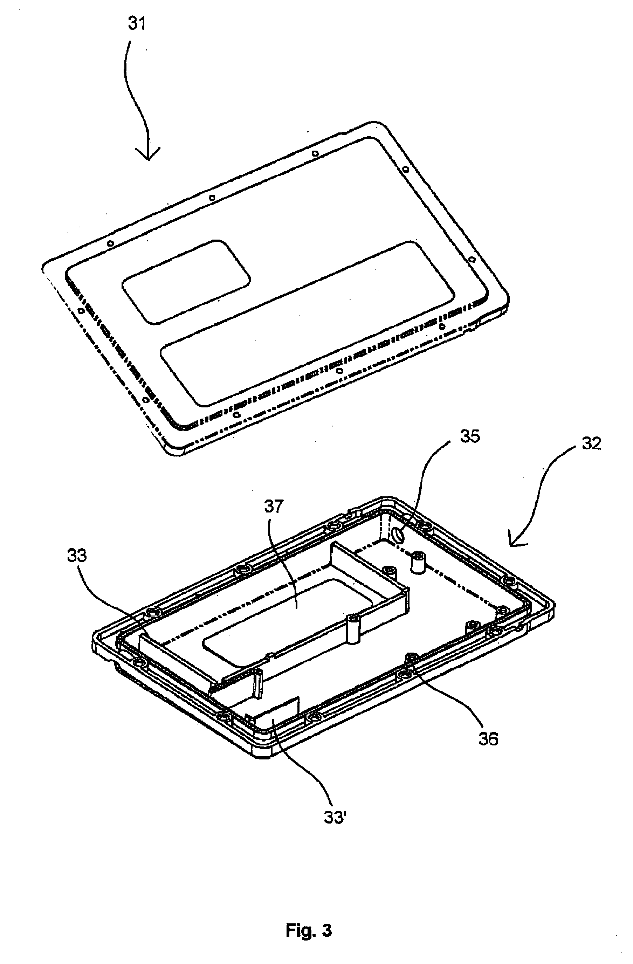

Ein Ausführungsbeispiel einer unteren Gehäusehälfte 32 ist in Fig. 3 dargestellt. Diese untere Gehäusehälfte 32 weist vorzugsweise wenigstens zwei Aufnahmen 33 und 33', in die Komponenten einer modularen Telematikeinheit eingebracht werden können. Eine Aufnahme wird dabei beispielsweise durch wenigstens zwei Seitenwände gebildet, zwischen die eine Komponente eingefügt werden kann. Darüber hinaus können Bohrlöcher vorhanden sein, um eingefügte Komponenten direkt über eine Schraube zu fixieren oder beispielsweise eine Abdeckplatte zu fixieren. Um die Komponenten innerhalb des Gehäuses 30 mit anderen Komponenten in der Schiene 10 verbinden zu können, ist wenigstens eine Öffnung 35 vorgesehen, durch welche Kabel geführt werden können. Es besteht jedoch auch die Möglichkeit, bereits im Randbereich des Gehäuses Anschlüsse vorzusehen, die in das Gehäuse integriert sind und von beiden Seiten kontaktiert werden können. Von innen würden dann die Komponenten des Gehäuses angeschlossen, während von außen beispielsweise das Solarpanel 40 an das Gehäuse angeschlossen wird, um die Komponenten der modularen Telematikeinheit direkt mit Energie zu versorgen bzw. einen Akkumulator zu laden.

In dem in Fig. 3 dargestellten Ausführungsbeispiel der Erfindung sind in einer ersten Aufnahme 33 Seitenwände vorgesehen, um einen Akkumulator zu positionieren, während ein kleinerer Bereich 33' zwei Seitenwände zur Aufnahme eines GPS-Moduls umfasst. Vorzugsweise weist die untere Gehäusehälfte 32 außen im Bereich der Aufnahme 33 für den Akkumulator eine Vertiefung 37 auf, die sich im Innern des Gehäuses als Erhöhung darstellt. Diese Vertiefung 37 kann zur Positionierung des Akkumulators, zur Luftspaltkühlung oder zur Einbringung eines Polsters beispielsweise aus Schaumstoff genutzt werden.

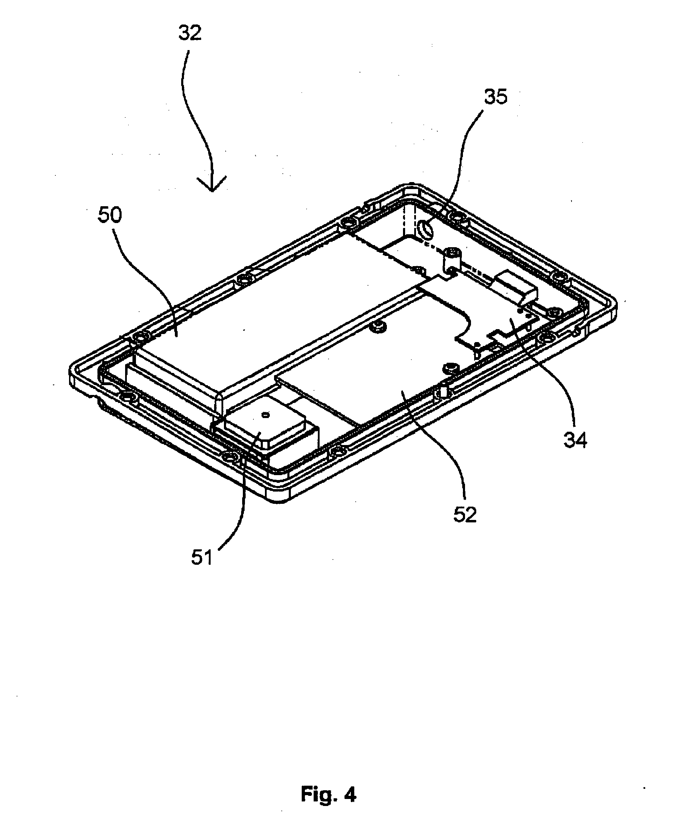

Fig. 4 zeigt, wie diese Komponenten einer modularen Telematikeinheit in die Aufnahmen 33 und 33' eingebracht werden. Der Akkumulator 50 ist in die Aufnahme 33 eingefügt, während das GPS-Modul 51 in die Aufnahme 33' eingebracht wurde. Ferner ist ersichtlich, dass neben dem Akkumulator 50 und dem GPS-Modul 51 eine Platine bzw. ein Mainboard 52 montiert wurde. Die Platine wird teilweise durch eine Abdeckplatte 34 abgedeckt. Zwischen den verschiedenen Aufnahmen liegt ausreichend Raum vor, um die einzelnen Komponenten über Kabel miteinander zu verbinden. Gegebenenfalls können hierzu Kabelführungen oder vorgefertigte Anschlüsse vorgesehen sein.

Die in Fig. 4 beispielhaft dargestellten Komponenten sind nicht einschränkend zu verstehen, sondern das Gehäuse kann mit jeglichen anderen Komponenten einer modularen Telematikeinheit bestückt werden. Beispielsweise können Funk-Module, GSM-Module oder Sensoren wie Temperatursensoren montiert werden.

Ferner weist die untere Gehäusehälfte 32 vorzugsweise Bohrungen 36 zur Montage der oberen Gehäusehälfte 31 auf. Die beiden Gehäusehälften 31 und 32 können dabei verschraubt werden, oder Stifte einer Gehäusehälfte greifen in eine entsprechend ausgeformte Bohrung in der anderen jeweils anderen Gehäusehälfte ein. Alternativ oder als Ergänzung können jedoch jegliche Mittel zum Verbinden der beiden Gehäusehälften wie beispielsweise Haken, Klipsverbindungen, elastische Bänder, etc. vorgesehen sein.

Der Fig. 3 ist ferner eine Darstellung der oberen Gehäusehälfte 31 zu entnehmen, die in ihrer Außenfläche weitere Vertiefungen aufweist, die sich im Innern des Gehäuses als Erhebungen darstellen. Darüber hinaus befinden sich die wesentlichen Teile des Gehäuses 30 jedoch in der unteren Gehäusehälfte 32, die mit den Komponenten der modularen Telematikeinheit bestückt wird. Die obere Gehäusehälfte dient somit im Wesentlichen als Deckel des Gehäuses 30. Sie kann jedoch auch mit Streben oder Erhebungen versehen sein, die bei Montage des Deckels Kontakt zu Telematikkomponenten haben, was zu einer zusätzlichen Stabilisierung bzw. Fixierung der jeweiligen Komponente führt.

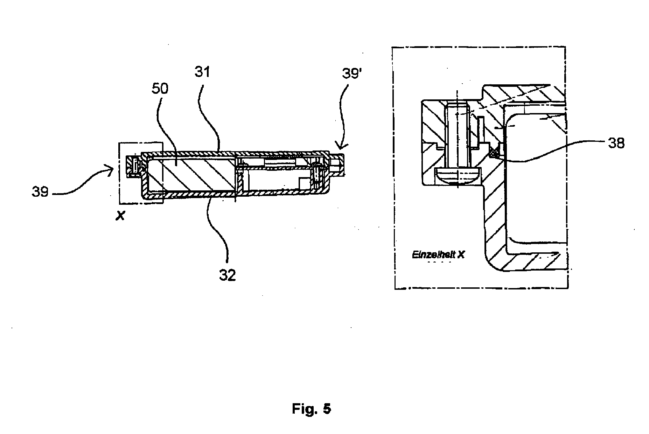

Fig. 5 zeigt einen Schnitt durch beide Gehäusehälften 31 und 32 nach dem Zusammenbau. Der Schnitt verläuft quer durch die Mitte des Gehäuses 30. Einem vergrößerten Ausschnitt dieses Zusammenbaus ist zu entnehmen, dass die Verbindung der beiden Gehäusehälften vorzugsweise mit einer Dichtung 38 erfolgt, um das Gehäuse wetterfest zu machen, so dass die innen liegenden Komponenten insbesondere nicht durch eindringendes Wasser beschädigt werden. Durch umlaufende Randerhebungen beider Gehäusehälften ergibt sich beim Zusammenbau wenigstens auf zwei gegenüber liegenden Seite jeweils eine Verdickung 39 und 39', die als Feder in der Nut einer jeweiligen Schiene geführt werden kann. Alternativ kann eine Feder jedoch auch nur an der Außenseite einer Gehäusehälfte ausgeformt sein, wobei hierfür beispielsweise die untere Gehäusehälfte vorgesehen sein kann, da diese in dem beschriebenen Ausführungsbeispiel größere Seitenflächen für die Anbringung einer Feder bietet.

In einem weiteren Ausführungsbeispiel der Erfindung können an dem Gehäuse 30 zwei seitliche Federn vorgesehen sein, die aus einem anderen Material als glasfaserverstärktem Kunststoff geformt sind, um einen Abrieb von Gehäusematerial bei wiederholtem Ein- und Ausbau des Gehäuses zu verhindern. Hierzu können beispielsweise Materialien wie Metalle oder Keramiken verwendet werden.

Möglich ist es ferner, die Schienen 21 und 22 als Federn auszuführen, während sich in dem Gehäuse 30 und auch in dem Solarpanel 40 zugehörige Nuten befinden, in welche die Bauteile über die Federn geführt werden. Eine Feder muss sich in allen Fällen nicht über die gesamte Länge eines Bauteils bzw. der Aufnahmevorrichtung 10 erstrecken, sondern es kann sich auch um einzelne blockförmige Elemente handeln, die in der zugehörigen Nut geführt werden.

Die Befestigung des Solarpanels 40 und des Gehäuses 30 an dem Grundkörper 20 der Aufnahmevorrichtung kann auf verschiedene Arten ausgeführt sein. Vorzugsweise erfolgt dies durch eine lösbare Schraubverbindung. Da als Material für das Gehäuse vorzugsweise ein glasfaserverstärkter Kunststoff gewählt wird, während der Grundkörper 20 aus einem Metall wie beispielsweise einer Al-Mn-Legierung besteht, kommt es bei Erwärmung der Aufnahmevorrichtung beispielsweise auf der Oberseite eines Containers, welcher der Sonneneinstrahlung ausgesetzt ist, zu einer Wärmeausdehnung der einzelnen Komponenten. Aufgrund der unterschiedlichen Wärmeausdehnungen der verwendeten Materialien kann es jedoch zu Spannungen zwischen den Bauteilen kommen, wenn sich diese unterschiedlich stark ausdehnen.

Eine Lösung dieses Problems stellt eine flexible Verbindung der Komponenten mit dem Grundkörper der Aufnahmevorrichtung dar. Da eine solche flexible Verbindung gegebenenfalls keine ausreichende Befestigung darstellt, hat sich eine Kombination aus einer festen Verbindung und einem Loslager als vorteilhaft erwiesen. Das Gehäuse 30 wird beispielsweise an einer Seite mit einer Schraube und einer entsprechenden Bohrung fest an dem Grundkörper angeschraubt. Eine zweite Schraube greift dagegen in ein Langloch ein und die Schraube wird nur so fest gezogen, dass sie sich innerhalb des Langlochs bewegen kann. Die erste Schraube bewirkt eine ausreichende Befestigung des Gehäuses 30 am Grundkörper 20, während unterschiedliche Ausdehnungen des Gehäuses im Bezug zu dem Grundkörper durch eine Bewegung der zweiten Schraube innerhalb des Langlochs ausgeglichen werden können. Dabei befindet sich das Langloch vorzugsweise in dem Grundkörper 20.

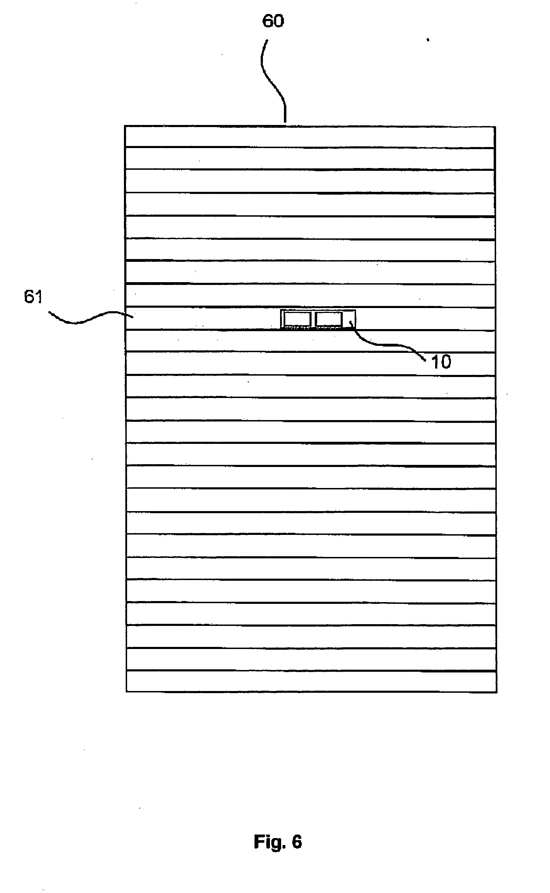

Fig. 6 zeigt die Oberseite eines Transportbehälters 60, auf der eine erfindungsgemäße Aufnahmevorrichtung 10 für eine mobile Telematikeinheit angebracht ist. Der Transportbehälter ist vorzugsweise ein Frachtcontainer bzw. eine Wechselbrücke aus Metall, wobei zur Versteifung des Behälterkörpers üblicherweise mehrfach gefalzte Metallplatten verwendet werden. Durch die Falze in den Metallplatten ergeben sich rillenförmige Vertiefungen 61, die üblicherweise quer über die Seitenwände und die Decke des Transportbehälters verlaufen. In diese rillenförmigen Vertiefungen 61 kann die erfindungsgemäße Aufnahmevorrichtung 10 für eine modulare Telematikeinheit vorteilhaft eingebracht werden. In diesem Fall wird die Aufnahmevorrichtung 10 somit quer zur Transport- oder Fahrtrichtung des Transportbehälters 60 auf der Oberseite des Transportbehälters 60 angebracht.

Je nach Anwendungsfall kann die erfindungsgemäße Aufnahmevorrichtung für eine modulare Telematikeinheit jedoch auch längs zur Fahrtrichtung und/oder an den Seitenwänden des Transportcontainers angebracht werden.

Die Aufnahmevorrichtung 10 kann an dem Transportbehälter 60 verschraubt werden oder weist beispielsweise wenigstens einen Magneten auf, über den die Aufnahmevorrichtung 10 an der metallischen Decke des Transportbehälters befestigt werden kann. Diese Ausführungsform ermöglicht eine leichte Montage und auch Demontage der erfindungsgemäßen Aufnahmevorrichtung an einem Transportbehälter. Für mögliche Verschraubungen kann die Aufnahmevorrichtung 10 wenigstens eine Bohrung aufweisen.

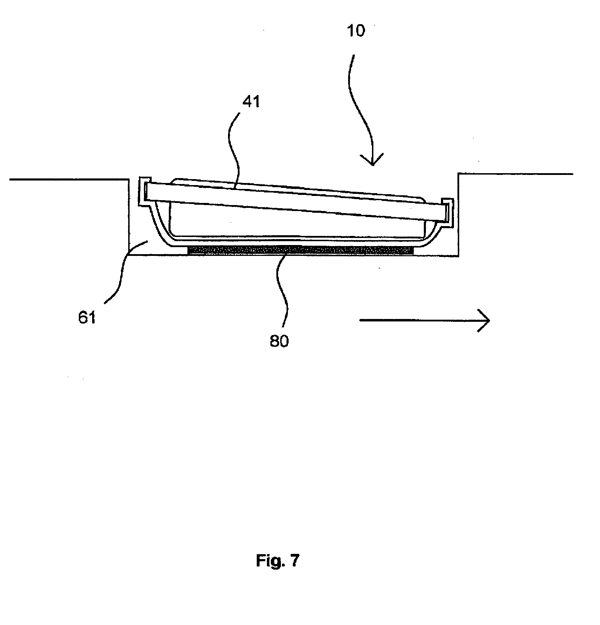

Die Anbringung einer Aufnahmevorrichtung an der Oberseite eines Transportbehälters ist in einem Detailausschnitt nochmals in Fig. 7 gezeigt. Hierbei ist die Aufnahmevorrichtung in eine rillenförmige Vertiefung 61 eingebracht und dort mit einem Magneten 80 fixiert. Die Höhe der Aufnahmevorrichtung ist vorzugsweise so gewählt, dass sie in der rillenförmigen Vertiefung 61 versenkt werden kann, ohne dass sie wesentlich aus der Vertiefung hervorragt. Insbesondere können so mehrere Transportbehälter übereinander gestapelt werden, ohne dass daran angebrachte Telematikeinheiten beschädigt werden. Ferner steht die äußere Oberfläche 41 des Solarpanels 40 schräg zur Transport- oder Fahrtrichtung des Transportbehälters, die in Fig. 7 mit einem Pfeil angegeben ist.

In einem anderen Ausführungsbeispiel der Erfindung kann die Aufnahmevorrichtung jedoch beispielsweise auch an der Tür eines Transportbehälters angebracht werden. In diesem Fall könnte die Aufnahmevorrichtung senkrecht an der Tür angebracht und mit einem Schalter versehen werden, der mit der Telematikeinheit der Aufnahmevorrichtung in Verbindung ist. Durch Öffnen oder Schließen der Tür, wird der Schalter betätigt, so dass die Telematikeinheit aktiviert oder deaktiviert wird. Auch in diesem Fall ist es vorteilhaft, dass die Aufnahmevorrichtung flach ausgebildet ist und gegebenenfalls auch hier in einer rillenförmigen Vertiefung innerhalb der Tür versenkt werden kann.

### Bezugszeichenliste:

- 10: Aufnahmevorrichtung
- 20: Grundkörper
- 21,22: Schiene
- 23: Bodenplatte
- 24: Äußere Oberfläche der Bodenplatte
- 30: Gehäuse
- 31,32: untere/obere Gehäusehälfte
- 33: Aufnahme
- 34: Abdeckplatte
- 35: Öffnung; Kabelführung
- 36: Bohrung
- 37: Vertiefung/Erhöhung
- 38: Dichtung
- 39,39': Verdickung
- 40: Solarpanel
- 41: Äußere Oberfläche des Solarpanels
- 50: Akkumulator
- 51: GPS-Modul
- 52: Platine, Mainboard
- 60: Transportbehälter, Frachtcontainer, Wechselbrücke
- 61: Vertiefung
- 70: Luftraum
- 80: Magnet

- h: Höhe Luftraum

## Patentansprüche

1. Aufnahmevorrichtung für eine modulare Telematikeinheit,
wobei die Aufnahmevorrichtung (10) einen Grundkörper (20) aufweist, der wenigstens zwei gegenüber liegende Schienen (21 ;22) umfasst,
wobei der Grundkörper (20) eine Bodenplatte (23) aufweist, an deren Seiten die Schienen (21 ;22) angebracht sind,
wobei zwischen die Schienen (21 ;22) lösbar wenigstens ein Gehäuse (30) und ein Solarpanel (40) eingeschoben sind, wobei das Gehäuse (30) wesentliche Komponenten der modularen Telematikeinheit aufnimmt,
wobei eine Schrägstellung des Solarpanels (40) durch die Schienen (21;22) erreicht wird, indem die Schienen parallel zu der Bodenplatte (23) verlaufen und der jeweilige
Abstand der Schienen (21 ;22) zu der Bodenplatte (23) unterschiedlich ist, wodurch die äußere Oberfläche (41) des Solarpanels (40) schräg in einem Winkel α zu der äußeren, gegenüber liegenden Oberfläche (24) der Bodenplatte (23) verläuft.

2. Aufnahmevorrichtung nach Anspruch 1,
**dadurch gekennzeichnet,**
**dass** das Gehäuse (30) mehrteilig ist, wobei das Gehäuse (30) durch einen flachen Längsschnitt in wenigstens zwei Gehäusehälften (31;32) aufgeteilt ist.

3. Aufnahmevorrichtung nach einem der Ansprüche 1 und 2,
**dadurch gekennzeichnet,**
**dass** das Gehäuse (30) aus glasfaserverstärktem Kunststoff besteht.

4. Aufnahmevorrichtung nach einem der Ansprüche 1 bis 3,
**dadurch gekennzeichnet,**
**dass** in dem Gehäuse (30) wenigstens eine Aufnahme (33;33') ausgeformt ist, wobei in die jeweilige Aufnahme (33;33') ein Akkumulator (50), ein GPS-Modul (51), ein Funkmodul, ein Sensor oder eine Platine (52) eingebracht ist.

5. Aufnahmevorrichtung nach einem der vorstehenden Ansprüche,
**dadurch gekennzeichnet,**
**dass** der Winkel α zwischen 1° bis 5° liegt.

6. Aufnahmevorrichtung nach einem der vorherigen Ansprüche,
**dadurch gekennzeichnet,**
**dass** zwischen der Bodenplatte (23) des in die Schienen (21;22) eingeschobenen Gehäuses (20) und der Bodenplatte (23) des Grundkörpers (20) ein Luftraum (70) vorliegt.

7. Aufnahmevorrichtung nach Anspruch 6
**dadurch gekennzeichnet,**
die Höhe h des Luftraums (70) zwischen 0,5 mm und 8 mm liegt.

8. Aufnahmevorrichtung nach einem der vorherigen Ansprüche,
**dadurch gekennzeichnet,**
**dass** das Gehäuse (30) mit wenigstens zwei Schraubverbindungen an dem Grundkörper (20) befestigt ist, wobei eine erste Schaubverbindung ein Festlager ist, während eine zweite Schraubverbindung ein Loslager mit einem Langloch umfasst.

9. Aufnahmevorrichtung nach einem der vorherigen Ansprüche,
**dadurch gekennzeichnet,**
**dass** der Grundkörper (20) wenigstens einen Magneten (80) aufweist.

10. Transportbehälter,
**dadurch gekennzeichnet,**
**dass** der Transportbehälter (60) eine Aufnahmevorrichtung (10) gemäß einem der Ansprüche 1 bis 9 aufweist.

11. Transportbehälter nach Anspruch 10,
**dadurch gekennzeichnet,**
**dass** der Transportbehälter (60) ein Frachtcontainer oder eine Wechselbrücke ist, wobei der Transportbehälter (60) an seiner Außenseite rillenförmige Vertiefungen (61) aufweist und die Aufnahmevorrichtung (10) in eine rillenförmige Vertiefung (61) eingebracht ist.

## Claims

1. A receptacle device for a modular telematic unit,
whereby the receptacle device (10) has a body (20) comprising at least two rails (21; 22) situated opposite from each other, whereby the body (20) has a baseplate (23) onto whose sides the rails (21; 22) are attached, whereby between the rails (21;22) at least one housing (30) and one solar panel (40) are detachably slid in, whereby the housing (30) accommodates essential components of the modular telematic unit,
whereby a slanted position of the solar panel (40) is achieved by the rails (21;22) in that the rails run parallel to the baseplate (23), and the specific distance of the rails (12; 22) to the baseplate (23) is different, as a result of which the outer surface (41) of the solar panel (40) is slanted at an angle α relative to the outer, opposite surface (24) of the baseplate (23).

2. The receptacle device according to Claim 1,
**characterized in that**
the housing (30) consists of several parts, whereby the housing (30) is divided into at least two housing halves (31; 32) by a flat, lengthwise cut.

3. The receptacle device according to either Claim 1 or Claim 2,
**characterized in that**
the housing (30) is made of fiberglass-reinforced plastic.

4. The receptacle device according to one of Claims 1 to 3,
**characterized in that**
at least one receptacle (33; 33') is formed in the housing (30), whereby an accumulator (50), a GPS module (51), a radio module, a sensor or a printed circuit board (52) is inserted into the appropriate receptacle (33; 33').

5. The receptacle device according to one of the preceding claims,
**characterized in that**
the angle α is between 1° and 5°.

6. The receptacle device according to one of the preceding claims,
**characterized in that**
there is an air space (70) between the baseplate (23) of the housing (20) that has been slid into the rails (21; 22) and the baseplate (23) of the body (20).

7. The receptacle device according to Claim 6,
**characterized in that**
the height h of the air space (70) is between 0.5 mm and 8 mm.

8. The receptacle device according to one of the preceding claims,
**characterized in that**
the housing (30) is attached to the body (20) by means of at least two screwed connections, whereby a first screwed connection is a fixed bearing while a second screwed connection is a floating bearing with a longitudinal slot.

9. The receptacle device according to one of the preceding claims,
**characterized in that**
the body (20) has at least one magnet (80).

10. A transportation container,
**characterized in that**
the transportation container (60) has a receptacle device (10) according to one of Claims 1 to 9.

11. The transportation container according to Claim 10,
**characterized in that**
the transportation container (60) is a freight container or a swap body, whereby the transportation container (60) has channel-shaped depressions (61) on the outside and the receptacle device (10) is inserted into a channel-shaped depression (61).

## Revendications

1. Dispositif de réception pour une unité télématique modulaire,
dans lequel le dispositif de réception (10) présente un corps de base (20) qui comprend au moins deux rails opposés (21 ; 22),
dans lequel le corps de base (20) présente une plaque de fond (23) sur les côtés de laquelle les rails (21 ; 22) sont montés,
dans lequel au moins un logement (30) et un panneau solaire (40) sont insérés de manière amovible entre les rails (21 ; 22), dans lequel le logement (30) reçoit des composants essentiels de l'unité télématique modulaire, dans lequel une position inclinée du panneau solaire (40) est obtenue grâce aux rails (21 ; 22) en ce que les rails s'étendent parallèlement à la plaque de fond (23) et l'écart respectif des rails (21 ; 22) à la plaque de fond (23) est différent, moyennant quoi la surface extérieure (41) du panneau solaire (40) s'étend en biais à un angle α par rapport à la surface extérieure opposée (24) de la plaque de fond (23).

2. Dispositif de réception selon la revendication 1,
**caractérisé en ce**
**que** le logement (30) est en plusieurs parties, dans lequel le logement (30) est divisé en au moins deux moitiés de logement (31 ; 32) par une coupe longitudinale plate.

3. Dispositif de réception selon l'une quelconque des revendications 1 et 2,
**caractérisé en ce**
**que** le logement (30) se compose de plastique renforcé par des fibres de verre.

4. Dispositif de réception selon l'une quelconque des revendications 1 à 3,
**caractérisé en ce**
**qu'**au moins une réception (33 ; 33') est formée dans le logement (30), un accumulateur (50), un module GPS (51), un module radio, un capteur ou une platine (52) étant introduit dans la réception respective (33 ; 33').

5. Dispositif de réception selon l'une quelconque des revendications précédentes,
**caractérisé en ce**
**que** l'angle α se situe entre 1° et 5°.

6. Dispositif de réception selon l'une quelconque des revendications précédentes,
**caractérisé en ce**
**qu'**un espace à air (70) est présent entre la plaque de fond (23) du logement (30) inséré dans les rails (21 ; 22) et la plaque de fond (23) du corps de base (20).

7. Dispositif de réception selon la revendication 6,
**caractérisé en ce**
**que** la hauteur h de l'espace à air (70) se situe entre 0,5 mm et 8 mm.

8. Dispositif de réception selon l'une quelconque des revendications précédentes,
**caractérisé en ce**
**que** le logement (30) est fixé avec au moins deux connexions vissées au corps de base (20), dans lequel une première connexion vissée est un palier fixe tandis qu'une seconde connexion vissée est un palier libre avec un trou oblong.

9. Dispositif de réception selon l'une quelconque des revendications précédentes,
**caractérisé en ce**
**que** le corps de base (20) présente au moins un aimant (80).

10. Récipient de transport,
**caractérisé en ce**
**que** le récipient de transport (60) présente un dispositif de réception (10) selon l'une quelconque des revendications 1 à 9.

11. Récipient de transport selon la revendication 10,
**caractérisé en ce**
**que** le récipient de transport (60) est un conteneur de fret ou une caisse mobile, dans lequel le récipient de transport (60) présente des renfoncements en forme de rainure (61) sur son côté externe et le dispositif de réception (10) est introduit dans un renfoncement en forme de rainure (61).
